# DEMANDE DE BREVET EUROPEEN

(11) **EP 3 826 077 A1**
(43) Date de publication de la demande: **26.05.2021**
(21) Numéro de dépôt: 20207841.6
(22) Date de dépôt: 16.11.2020
(51) Int. Cl.: H01L 31/068, H01L 31/18, H01L 31/0288, H01L 31/0376, H01L 31/0224

(54) **PROCÉDÉ DE FABRICATION D'UNE CELLULE PHOTOVOLTAÏQUE**

(30) Priorité: 21.11.2019 FR 1913002
(71) Demandeur: Commissariat à l'énergie atomique et aux énergies alternatives, 75015 Paris (FR)
(72) Inventeur: BELLANGER, Pierre, 38054 GRENOBLE CEDEX 09 (FR); DESRUES, Thibaut, 38054 GRENOBLE CEDEX 09 (FR)
(74) Mandataire: Brevalex

(57) **Abrégé**

L'invention concerne un procédé de fabrication d'une cellule photovoltaïque dans un substrat (10), le procédé comprenant :
a) une étape d'implantation surfacique d'espèces dopantes, exclusivement à partir de la première face (11), de manière à former une première couche dopée (13) selon une profondeur P ;
b) une étape de formation d'une couche de matériau antireflet (16) sur la première face (11) ;
c) une étape de dépôt d'une pâte métallique selon un premier motif sur la couche (16), la pâte métallique étant adaptée pour diffuser à travers la couche (16), lorsqu'elle est soumise à un traitement thermique, de manière à former des contacts métalliques (19) avec la première couche dopée (13) ;
d) une étape de traitement thermique à une température supérieure à la température prédéterminée, de manière à activer.

## Description

### DOMAINE TECHNIQUE

La présente invention concerne le domaine de l'industrie photovoltaïque et plus particulièrement celui des cellules photovoltaïques.

L'invention propose un procédé de formation d'une jonction pn ou « high/low » (n/n+ ou p/p+), et notamment d'une jonction d'une cellule photovoltaïque.

En particulier, La présente invention propose un procédé permettant de former, de manière simplifiée au regard des procédés connus de l'état de la technique, une cellule photovoltaïque.

### ÉTAT DE LA TECHNIQUE ANTÉRIEURE

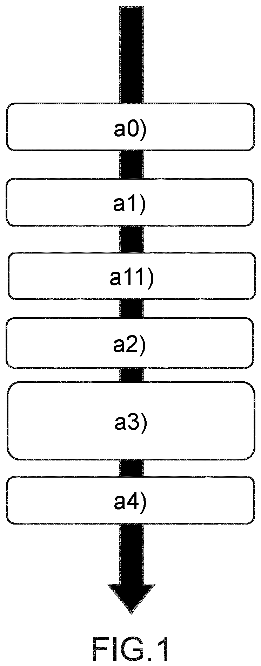

Un procédé de formation d'une cellule photovoltaïque sur un substrat, notamment un substrat de silicium, connu de l'étape de la technique est illustré à la figure 1.

Ce procédé comprend les étapes suivantes :
a1) une étape de diffusion d'espèces dopantes à haute température de manière à former une couche dopée qui s'étend à partir d'une face, dite première face, du substrat selon une profondeur P ;
a2) une étape de formation d'une couche antireflet en recouvrement de la première face ;
a3) une étape de métallisation au moyen d'une pâte métallique adaptée pour diffuser à travers la couche antireflet lorsqu'elle est soumise à une température supérieure à une température prédéterminée de manière à former des contacts métalliques qui comprennent une zone de contact électrique avec la couche dopée ;
a4) une étape de traitement thermique à une température supérieure à la température prédéterminée de manière à former les contacts métalliques.

Le procédé peut également comprendre une étape a11) de texturation de la première face exécutée entre les étapes a1) et a2).

De manière alternative, les étapes a2) et a3) peuvent être inversées.

Lors de l'exécution de l'étape a1), le substrat est disposé dans un four de diffusion adapté pour imposer audit substrat une élévation de température, notamment supérieure à la température prédéterminée.

L'atmosphère du four comprend également un précurseur de l'espèce dopante. Ce dernier peut par exemple comprendre du POCl₃, dès lors qu'il s'agit de former une couche dopée N.

Cependant, lors de l'exécution de cette étape a1), une deuxième face du substrat, opposée à la première face, est également exposée au précurseur de sorte qu'il se forme également une deuxième couche dopée qui s'étend à partir de la deuxième face.

Par ailleurs, toujours à l'issue de cette étape a1), la première et la deuxième face sont recouvertes de couches parasites formées par des résidus du précurseur.

Par conséquent, la deuxième couche dopée ainsi que les couches parasites nécessitent la mise en œuvre d'une étape de retrait, et notamment par gravure, qui est source de complexification du procédé de formation de la jonction.

Par ailleurs, cette étape présente un coût qu'il est souhaitable d'éviter, notamment lorsqu'il s'agit de fabriquer des jonctions sur des cellules photovoltaïques.

En outre, l'étape a1) de dopage par diffusion rend très difficile, voire impossible, la formation de jonctions courtes, et notamment d'épaisseur inférieure à 300 nm, voire inférieure à 200 nm.

Ce type de jonctions courtes, notamment dans le domaine des cellules photovoltaïques, ouvre la voie à une amélioration des performances et en particulier du rendement desdites cellules.

Ainsi, un but de la présente invention est de proposer un procédé de formation d'une cellule photovoltaïque, plus simple à mettre en œuvre au regard du procédé connu de l'état de la technique.

Un autre but de la présente invention est de proposer un procédé de formation d'une cellule photovoltaïque qui peut être mis en œuvre sur une ligne de fabrication préexistante.

Un autre but de la présente invention est de proposer un procédé d'une cellule photovoltaïque pourvue de jonctions dites courtes.

### EXPOSÉ DE L'INVENTION

Les buts d'invention sont, au moins en partie, atteints par un procédé de fabrication d'une cellule photovoltaïque dans ou sur un substrat de silicium initialement dopé avec des espèces dopantes d'un type donné, la cellule photovoltaïque étant pourvue d'une première couche dopée dopée avec des premières espèces dopantes d'un autre type que les espèces dopantes et qui s'étend depuis une première face du substrat de silicium selon une profondeur P, la première face étant opposée à une deuxième face dudit substrat, le procédé comprenant les étapes suivantes :
a) une étape d'implantation surfacique des premières espèces dopantes, exclusivement à partir de la première face, de manière à former la première couche dopée ;
b) une étape de formation d'une couche de matériau antireflet sur la première face ;
c) une étape de dépôt d'une pâte métallique selon un ou plusieurs premiers motifs prédéfinis sur la couche de matériau antireflet ; la pâte métallique étant adaptée pour diffuser à travers la couche de matériau antireflet, lorsqu'elle est soumise à une température supérieure à une température prédéterminée, de manière à former des contacts métalliques qui comprennent une zone de contact en contact électrique avec la première couche dopée;
d) une étape de traitement thermique à une température supérieure à la température prédéterminée, de manière à activer les premières espèces dopantes dans la couche dopée et former les contacts métalliques.

Selon un mode de mise en œuvre, une étape a0) de texturation de la première face est exécutée avant l'étape a).

Selon un mode de mise en œuvre, le substrat de silicium est formé, avant exécution de l'étape a), d'un empilement d'un substrat support en silicium cristallin et d'une couche de silicium amorphe dont l'une des faces forme la première face du substrat.

Selon un mode de mise en œuvre, les premières espèces dopantes sont implantées dans la couche de silicium amorphe lors de l'exécution de l'étape a), et dans lequel ladite couche de silicium amorphe est recristallisée lors de l'exécution de l'étape d).

Selon un mode de mise en œuvre, l'étape a) est exécutée par immersion plasma.

Selon un mode de mise en œuvre, la dose des premières espèces dopantes implantées est comprise entre 10¹⁴ atomes / cm² et 10¹⁷ atomes / cm².

Selon un mode de mise en œuvre, l'étape a) est exécutée de sorte que la profondeur P est inférieure à 300 nm, avantageusement inférieure à 200 nm.

Selon un mode de mise en œuvre, l'étape a) est exécutée de sorte que la concentration en premières espèces dopantes, dans une première région de la première couche dopée qui s'étend à partir de première face selon une profondeur P1 inférieure à la profondeur P, soit supérieure à 10²⁰ atomes / cm³.

Selon un mode de mise en œuvre, la pâte métallique est également adaptée pour, lors de l'exécution de l'étape d) de traitement thermique, que la zone de contact s'étende dans la première couche dopée sur une profondeur inférieure ou égale à la profondeur P1.

Selon un mode de mise en œuvre, l'étape b) comprend la mise en œuvre d'une technique de dépôt chimique en phase vapeur activée par plasma.

Selon un mode de mise en œuvre, la couche de matériau antireflet est d'une épaisseur comprise entre 50 nm et 100 nm.

Selon un mode de mise en œuvre, la couche de matériau antireflet comprend au moins un des composés choisi parmi : nitrure de silicium, oxyde conducteur transparent.

Selon un mode de mise en œuvre, le dépôt de la pâte métallique est exécuté par sérigraphie.

Selon un mode de mise en œuvre, l'étape c) comprend également le dépôt de la pâte métallique selon un ou plusieurs deuxièmes motifs prédéfinis sur la deuxième face de manière à former d'autres contacts métalliques sur ladite deuxième face.

Selon un mode de mise en œuvre, le substrat de silicium comprend une deuxième couche dopée selon le même type de dopage que la première couche dopée, et qui s'étend selon une profondeur P2 à partir de la deuxième face, ladite deuxième couche dopée étant recouverte d'une couche de passivation.

Selon un mode de mise en œuvre, l'étape d) de traitement thermique est une étape de recuit rapide exécutée dans un four à passage ou un four de recuit thermique rapide.

### BRÈVE DESCRIPTION DES DESSINS

D'autres caractéristiques et avantages apparaîtront dans la description qui va suivre d'un procédé de formation d'une cellule photovoltaïque, donnés à titre d'exemples non limitatifs, en référence aux dessins annexés dans lesquels :
La figure 1 est une représentation logique de l'enchainement des étapes d'un procédé de fabrication d'une jonction connu de l'état de la technique ;
Les figures 2A, 2B, 2C, 2D, 2E sont des représentations schématiques des différentes étapes d'un procédé de fabrication d'une jonction selon la présente invention ;
La figure 3 est une représentation graphique de deux profils d'implantation « A » et « B » des premières espèces dopantes obtenus selon des conditions d'implantation surfacique différentes, en particulier, les profils « A » et « B » représentent la concentration des premières espèces dopantes implantées (axe vertical, unité [atomes/cm³]), en fonction de la distance dans le substrat de silicium repérée à partir de la première face (axe horizontal, unité [µm]) ;
La figure 4 est une représentation schématique d'un substrat de silicium formé d'une couche de silicium amorphe reposant sur un substrat support fait de silicium ;
La figure 5 est une représentation schématique d'un substrat de silicium qui comprend également la deuxième couche dopée.

### EXPOSÉ DÉTAILLÉ DE MODES DE RÉALISATION PARTICULIERS

La présente invention concerne un procédé de fabrication d'une cellule photovoltaïque dans un substrat de silicium. La cellule est, à cet égard, pourvue d'une première couche dopée qui forme, avec le substrat de silicium dans lequel elle est formée, une jonction. Le procédé selon la présente invention permet également de former des contacts (électriques) sur la première couche dopée.

Ainsi, le procédé comprend une étape d'implantation surfacique de premières espèces dopantes exclusivement à partir de la première face afin de former la première couche dopée qui s'étend depuis de la première face et selon une profondeur P.

Cette étape d'implantation surfacique est alors suivie de la formation d'une couche de matériau antireflet en recouvrement de la première face.

Une étape de métallisation de la couche de matériau antireflet, selon un ou plusieurs motifs prédéfinis, est ensuite exécutée en vue de réaliser des contacts métalliques. Cette étape de métallisation met notamment en œuvre le dépôt d'une pâte métallique, par exemple par sérigraphie, sur la couche de matériau antireflet. Ladite pâte est en particulier adaptée pour, lorsqu'elle est soumise à un traitement thermique, diffuser à travers la couche de matériau antireflet et réaliser un ou plusieurs contacts avec la première couche dopée.

À cet égard, le procédé selon la présente invention comprend alors une étape de traitement thermique destinée non seulement à réaliser l'un ou plusieurs contacts, mais également à activer les premières espèces dopantes dans la première couche dopée.

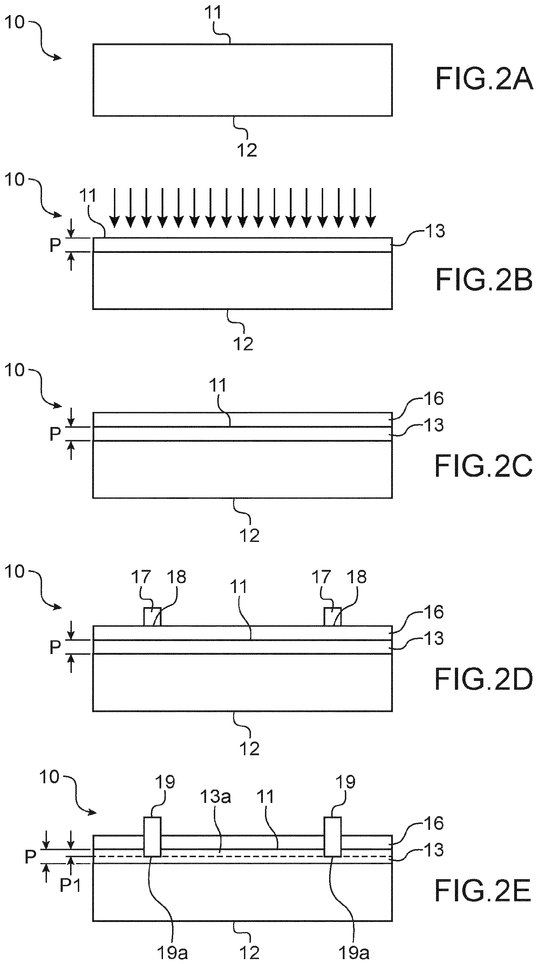

Sur les figures 2A à 2E, on peut voir un exemple de procédé de réalisation d'une cellule photovoltaïque et plus particulièrement de fabrication d'une jonction, et des contacts qui lui sont associés, sur une première face 11, opposée à une deuxième face 12, d'un substrat de silicium 10 selon la présente invention (figure 2A).

Le substrat de silicium 10 est notamment dopé avec des espèces dopantes d'un type donné N ou P, par exemple du bore (dopage de type P).

Le substrat de silicium 10 peut présenter une épaisseur comprise entre 100 µm et 200 µm

Le substrat de silicium 10, illustré à la figure 2A, peut comprendre du silicium monocristallin ou du silicium poly cristallin.

La première face 11 du substrat de silicium 10 peut présenter une texturation destinée à accroitre sa surface utile.

Le procédé selon la présente invention comprend une étape a), illustrée à la figure 2B et symbolisée par les flèches « I », d'implantation surfacique de premières espèces dopantes de manière à former une première couche dopée 13 qui s'étend depuis de la première face 11 et selon une profondeur P.

A cet égard, les première espèces dopantes sont d'un premier type autre que le type donné, et peuvent comprendre du phosphore et/ou de l'arsenic.

La dose des premières espèces dopantes implantées peut être comprise entre 10¹⁴ atomes / cm² et 10¹⁷ atomes / cm².

Par « technique d'implantation surfacique », on entend une technique d'implantation qui permet de créer un profil d'implantation qui s'étend à partir de la première face, et décroissant en termes de concentration d'espèces implantées à partir de ladite première face. À titre d'exemple, l'implantation surface peut comprendre une implantation par immersion plasma ou une implantation par faisceau d'ions.

Ces techniques, connues de l'homme du métier, permettent de n'exposer à l'implantation des premières espèces dopantes qu'une seule des deux faces du substrat de silicium, et ainsi de préserver l'autre face. En d'autres termes, l'étape d'implantation surfacique selon la présente invention ne conduit pas à la formation d'une couche dopée supplémentaire s'étendant à partir de la deuxième face ou à la croissance de couches parasites tel qu'observé à l'issue d'une étape de diffusion.

Par ailleurs, contrairement à une étape de diffusion, l'étape d'implantation surfacique ne conduit pas à la formation de couches parasites sur la première et la deuxième face.

Néanmoins, les premières espèces dopantes implantées lors de l'étape a) nécessitent la mise en œuvre d'une étape de traitement (nommée dans la suite de l'énoncé étape d)) destinée à les activer.

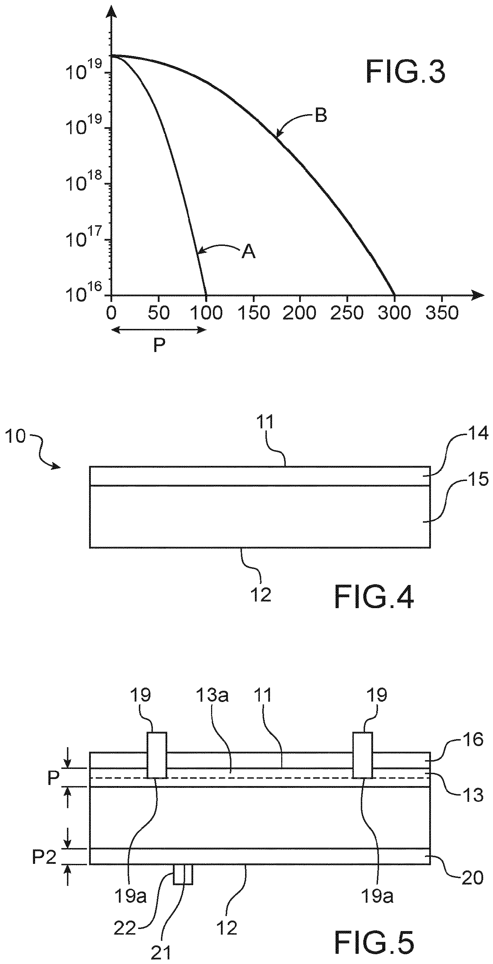

La figure 3 est une représentation graphique de deux profils d'implantation « A » et « B » des premières espèces dopantes obtenus selon des conditions d'implantation surfacique différentes. En particulier, les profils « A » et « B » représentent la concentration des premières espèces dopantes implantées (axe vertical, unité [atomes/cm³]), en fonction de la distance dans le substrat de silicium repérée à partir de la première face 11 (axe horizontal, unité [µm]).

Selon la présente invention, la profondeur P (d'autres termes l'épaisseur) de la première couche dopée est définie par le profil d'implantation des premières espèces dopantes. Notamment, la profondeur de la première couche dopée 13 correspond au domaine pour lequel la concentration des premières espèces dopantes est supérieure à 10¹⁶ atomes / cm³. Ainsi, la première couche dopée 13 définie par le profil « A » présente une épaisseur de 100 nm, tandis que celle relative au profil « B » présente une épaisseur de 300 nm.

De manière particulièrement avantageuse, les paramètres relatifs à l'exécution de l'étape d'implantation surfacique sont ajustés de sorte que la profondeur P est inférieure à 300 nm, voire inférieure à 200 nm. L'implantation surfacique permet ainsi de former des jonctions dites courtes, et ouvre ainsi la voie à l'amélioration des performances desdites jonctions.

Selon un mode de réalisation avantageux, l'étape a) d'implantation surfacique peut être exécutée de sorte que la concentration en premières espèces dopantes, dans une première région 13a de la première couche dopée qui s'étend à partir de première face selon une profondeur P1 inférieure à la profondeur P, soit supérieure à 10²⁰ atomes / cm³.

Selon une variante avantageuse, le substrat de silicium 10 peut comprendre, avant exécution de l'étape a), de sa première face 11 vers sa deuxième face 12, une couche de silicium amorphe 14 reposant sur un substrat support 15 fait de silicium cristallin (figure 4). Selon cette variante, l'exécution de l'étape a) comprend l'implantation des premières espèces dopantes dans la couche de silicium amorphe 14. Il apparaîtra également de manière évidente dans la suite de l'énonce que l'étape d) de traitement thermique est également destinée à recristalliser la couche de silicium amorphe 14.

Une couche d'oxyde tunnel SiOx intercalée entre la substrat support 15 et la couche de silicium amorphe peut être considérée.

Le procédé selon la présente invention comprend une étape b) de formation d'une couche de matériau antireflet 16 (figure 2B) en recouvrement de la première face 11.

A titre d'exemple, la couche de matériau antireflet 16 peut comprendre au moins un des composés choisi parmi : nitrure de silicium, oxyde conducteur transparent.

Par ailleurs, la couche de matériau antireflet 16 peut être d'une épaisseur comprise entre 50 nm et 100 nm, par exemple 70 nm.

L'exécution de l'étape b) peut comprendre la mise en œuvre d'une technique de dépôt chimique en phase vapeur activée par plasma.

L'étape b) est suivie d'une étape c) de dépôt d'une pâte métallique 17 selon un ou plusieurs premiers motifs 18 prédéfinis sur la couche de matériau antireflet 16.

Par « pâte métallique », on entend des particules métalliques dispersées dans un solvant avec de la frite de verre.

Les particules métalliques peuvent comprendre de l'argent ou de l'indium.

L'un ou plusieurs motifs peut comprendre des plots, des structures inter digités, ou encore des bandes. L'invention n'est toutefois pas limitée à ces seules structures.

La pâte métallique est notamment adaptée pour diffuser à travers la couche de matériau antireflet 16, lorsqu'elle est soumise à une température supérieure à une température prédéterminée par exemple comprise entre 770 °C et 1000 °C.

En particulier, la diffusion de la pâte métallique, et plus particulièrement des particules métalliques, est régie par la granulométrie desdites particules, de la porosité de la couche de matériau antireflet et de la température qui leur est imposée.

L'homme du métier est en mesure avec ses connaissances générales de trouver les meilleures conditions qui soient pour assurer la diffusion de la pâte métallique à travers la couche de matériau antireflet 16.

Cette capacité de la pâte métallique 17 à diffuser à travers la couche de matériau antireflet 18 sera, tel que discuté dans la suite de l'énoncé en relation avec la figure 2E, mise à profit pour former des contacts métalliques 19 qui comprennent une zone de contact 19a en contact électrique avec la première couche dopée 13.

Le dépôt de la pâte métallique peut être exécuté par sérigraphie.

Le procédé selon la présente invention comprend enfin une étape d) de traitement thermique.

Cette étape est notamment exécutée, tel que précisé précédemment, de manière à faire diffuser la pâte métallique à travers la couche de matériau antireflet 16 et permettre l'établissement d'une prise de contact au niveau de la première couche dopée 13.

Cette étape de traitement thermique permet également l'activation des premières espèces dopantes implantées, et si elle est considérée, la recristallisation de la couche de silicium amorphe 15.

L'étape de traitement thermique peut comprendre une élévation de température comprise entre 770 °C et 1000 °C, avantageusement entre 800 °C et 950 °C.

La durée de ce traitement thermique peut être comprise entre 20 secondes et 2 minutes.

A cet égard, l'étape d) de traitement thermique peut être une étape de recuit rapide exécutée dans un four à passage ou un four de recuit thermique rapide.

Par ailleurs dès lors que l'étape b) d'implantation surfacique conduit à la formation de la première région 13a, la pâte métallique peut également être adaptée pour, lors de l'exécution de l'étape d) de traitement thermique, que la zone de contact 19a s'étende dans la première couche dopée sur une profondeur inférieure ou égale à la profondeur P1. Cet aspect permet de limiter les pertes associées à la résistance de contact entre la zone de contact 19a et la première couche dopée 13.

La concentration des premières espèces implantées ainsi que la profondeur P peuvent être adaptées pour qu'à l'issue de l'étape d) de traitement thermique la résistance carrée de la première couche dopées soit inférieure à 150 Ohm / sq. Un tel niveau de résistance carrée permet de limiter les pertes dues à la résistance latérale.

Selon un mode de réalisation avantageux, le substrat de silicium 10 peut comprendre une deuxième couche dopée 20, et qui s'étend selon une profondeur P2 à partir de la deuxième face.

Le dopage de la deuxième couche dopée 20 peut être du même type que celui de la première couche dopée 13.

Ainsi, l'étape c) peut également comprendre le dépôt de la pâte métallique selon un ou plusieurs deuxièmes motifs 21 prédéfinis sur la deuxième face 12, de manière à former d'autres contacts métalliques 22 sur ladite deuxième face.

La présente invention ne comprend qu'une seule étape de traitement thermique qui est mise en œuvre à la fois pour activer les premières espèces dopantes et initier la diffusion de la pâte métallique. Cette étape de traitement thermique permet également de recristalliser la couche de silicium amorphe lorsqu'elle est considérée.

Par ailleurs, contrairement à une étape de diffusion, l'étape d'implantation surfacique ne conduit pas à la formation de couches parasites sur la première et la deuxième face ou encore une couche dopée sur la deuxième face.

Il n'est donc pas nécessaire d'avoir recours à une étape de retrait de couches parasites.

Le procédé selon la présente invention peut être mis en œuvre pour la réalisation de tout type de jonction, et par exemple pour des cellules du type p-PERC, TOP-CON ou encore tandem.

## Revendications

1. Procédé de fabrication d'une cellule photovoltaïque dans ou sur un substrat de silicium (10) initialement dopé avec des espèces dopantes d'un type donné, la cellule photovoltaïque étant pourvue d'une première couche dopée (13) dopée avec des premières espèces dopantes d'un autre type que les espèces dopantes et qui s'étend depuis une première face (11) du substrat de silicium (10) selon une profondeur P, la première face (11) étant opposée à une deuxième face (12) dudit substrat, le procédé comprenant les étapes suivantes :
a) une étape d'implantation surfacique des premières espèces dopantes, exclusivement à partir de la première face (11), de manière à former la première couche dopée (13) ;
b) une étape de formation d'une couche de matériau antireflet (16) sur la première face (11) ;
c) une étape de dépôt d'une pâte métallique selon un ou plusieurs premiers motifs (18) prédéfinis sur la couche de matériau antireflet (16) ; la pâte métallique étant adaptée pour diffuser à travers la couche de matériau antireflet (16), lorsqu'elle est soumise à une température supérieure à une température prédéterminée, de manière à former des contacts métalliques (19) qui comprennent une zone de contact (19a) en contact électrique avec la première couche dopée (13) ;
d) une étape de traitement thermique à une température supérieure à la température prédéterminée, de manière à activer les premières espèces dopantes dans la couche dopée et former les contacts métalliques (19).

2. Procédé selon la revendication 1, dans lequel une étape a0) de texturation de la première face (11) est exécutée avant l'étape a).

3. Procédé selon la revendication 1 ou 2, dans lequel le substrat de silicium (10) est formé, avant exécution de l'étape a), d'un empilement d'un substrat support (15) en silicium cristallin et d'une couche de silicium amorphe (14) dont l'une des faces forme la première face (11) du substrat (10), avantageusement, les premières espèces dopantes sont implantées dans la couche de silicium amorphe (14) lors de l'exécution de l'étape a), et dans lequel ladite couche de silicium amorphe (14) est recristallisée lors de l'exécution de l'étape d).

4. Procédé selon l'une des revendications 1 à 3, dans lequel l'étape a) est exécutée par immersion plasma.

5. Procédé selon l'une des revendications 1 à 4, dans lequel la dose des premières espèces dopantes implantées est comprise entre 10¹⁴ atomes / cm² et 10¹⁷ atomes / cm².

6. Procédé selon l'une des revendications 1 à 5, dans lequel l'étape a) est exécutée de sorte que la profondeur P est inférieure à 300 nm, avantageusement inférieure à 200 nm.

7. Procédé selon l'une des revendications 1 à 6, dans lequel l'étape a) est exécutée de sorte que la concentration en premières espèces dopantes, dans une première région (13a) de la première couche dopée (13) qui s'étend à partir de première face (11) selon une profondeur P1 inférieure à la profondeur P, soit supérieure à 10²⁰ atomes / cm³.

8. Procédé selon la revendication 7, dans lequel la pâte métallique est également adaptée pour, lors de l'exécution de l'étape d) de traitement thermique, que la zone de contact (19a) s'étende dans la première couche dopée (13) sur une profondeur inférieure ou égale à la profondeur P1.

9. Procédé selon l'une des revendications 1 à 8, dans lequel l'étape b) comprend la mise en œuvre d'une technique de dépôt chimique en phase vapeur activée par plasma.

10. Procédé selon l'une des revendications 1 à 9, dans lequel la couche de matériau antireflet (16) est d'une épaisseur comprise entre 50 nm et 100 nm.

11. Procédé selon l'une des revendications 1 à 10, dans lequel la couche de matériau antireflet (16) comprend au moins un des composés choisi parmi : nitrure de silicium, oxyde conducteur transparent.

12. Procédé selon l'une des revendications 1 à 11, dans lequel le dépôt de la pâte métallique est exécuté par sérigraphie.

13. Procédé selon l'une des revendications 1 à 12, dans lequel l'étape c) comprend également le dépôt de la pâte métallique selon un ou plusieurs deuxièmes motifs (21) prédéfinis sur la deuxième face (12) de manière à former d'autres contacts métalliques (22) sur ladite deuxième face (12).

14. Procédé selon l'une des revendications 1 à 13, dans lequel le substrat de silicium (10) comprend une deuxième couche dopée (20) selon le même type de dopage que la première couche dopée (13), et qui s'étend selon une profondeur P2 à partir de la deuxième face (12), ladite deuxième couche dopée étant recouverte d'une couche de passivation.

15. Procédé selon l'une des revendications 1 à 14, dans lequel l'étape d) de traitement thermique est une étape de recuit rapide exécutée dans un four à passage ou un four de recuit thermique rapide.
